# EUROPÄISCHE PATENTSCHRIFT

(11) **EP 2 435 544 B1**
(45) Veröffentlichungstag und Bekanntmachung des Hinweises auf die Patenterteilung: **30.04.2014**
(21) Anmeldenummer: 10705810.9
(22) Anmeldetag: 19.02.2010
(51) Int. Cl.: C10M 103/06, C10N 30/06, C10N 50/08, C10N 40/06, C10N 70/00

(54) **VERFAHREN ZUM AUFBRINGEN EINES HOCHTEMPERATURSCHMIERMITTELS**
METHOD FOR APPLYING A HIGH-TEMPERATURE LUBRICANT
PROCÉDÉ D'APPLICATION D'UN LUBRIFIANT HAUTE TEMPÉRATURE

(30) Priorität: 28.05.2009 DE 102009022982
(43) Veröffentlichungstag der Anmeldung: 04.04.2012
(73) Patentinhaber: Oerlikon Trading AG, Trübbach, 9477 Trübbach (CH)
(72) Erfinder: MOOSBRUGGER, Arno, 6971 Hard (AT); KERSCHBAUMER, Jörg, 6800 Feldkirch (AT); BACHMANN, Theo, 9469 Haag (CH); WALCH, Mario Wolfgang, 9493 Mauren (LI)
(74) Vertreter: Kempkens, Anke
(86) Internationale Anmeldenummer: PCT/EP2010/001061
(87) Internationale Veröffentlichungsnummer: WO 2010/136088

(56) Entgegenhaltungen:
- WO-A1-03/027213
- JP-A- 2009 062 443

## Beschreibung

Die vorliegende Erfindung betrifft ein Verfahren zum Aufbringen eines Hochtemperaturschmiermittels auf die Oberfläche eines Bestandteils einer Vakuumbeschichtungsquelle.

Die Verwendung von Schmiermittel ist eine weit verbreitete Massnahme um den mechanischen Verschleiss von aneinander reibenden Bauteilen zu verringern. Dabei ist auch bekannt dass die Schmiermittel den Umgebungsbedingungen angepasst werden sollten. Ein Schmiermittel, welches in einer Vakuumbeschichtungskammer eingesetzt wird, muss vakuumtauglich sein. Beispielsweise kommt hier MoS₂ in Frage. Ein Schmiermittel, welches in einer Umgebung mit hohen Temperaturen zur Anwendung kommt, muss diesen Temperaturen standhalten können. MoS₂ ist aber lediglich bis zu einer Temperatur von 450°C einsetzbar. Für höhere Temperaturen bis zu 1200°C eignet sich hexagonales Bohrnitrid (hBN), auch als anorganischer oder weisser Graphit bekannt. WO 03/027213-A1 offenbart einen Formkörper mit Bornitrid und ein Verfahren zum Einbringen oder Erzeugen von Bohrnitrid in eineden porösen Formkörper.

JP 2009 062 443 A offenbart einen Stift enthaltend hexagonalen Bohrnitrid.

Üblicherweise werden die aufzubringenden Schmiermittel auf die zu behandelnde Oberfläche aufgesprüht oder aufgepinselt. Beim Aufsprühen wird als Ausgangsmaterial eine Flüssigkeit (z.B. Alkohol) verwendet in die Schmiermittelteilchen suspensiert sind. Beim Aufpinseln wird ein feines Pulver aus Schmiermittelteilchen verwendet. Beides sind einfache und kostengünstige bekannte Verfahren. Für MoS₂ sind dies gut funktionierende Methode, da dieses Material genügend weich ist und an der rauen Oberfläche haftet. Dies trifft allerdings nicht für hBN zu. Wird dieses hBN auf eine raue Überfläche gesprüht oder gepinselt, so kommt es im Wesentlichen locker auf der Oberfläche zu liegen und kann leicht abgewischt werden. Aufgesprühte oder aufgepinselte Bornitridschichten müssen daher häufig erneuert werden, möchte man nicht riskieren, dass die aneinander reibenden Teile schnell verschleissen und zu Bruch gehen.

Es besteht daher ein Bedürfnis nach einem Verfahren, welches es gestattet in einfacher Weise hexagonales Bornitrid (hBN) auf eine raue Oberfläche haftend aufzutragen derart, dass wesentliche Bestandteile der aufgetragenen Bornitridschicht sich nicht einfach abwischen lassen.

In dem erfindungsgemässen Verfahren wird ein Festkörper, welcher im Wesentlichen gepresstes hBN Pulver umfasst, über die raue Oberfläche gerieben und zwar derart, dass hBN vom Festkörper abgerieben. Dies wird dadurch erzielt dass der Festkörper mit Druck über die Oberfläche bewegt wird und an der zu behandelnden Oberfläche hängen bleibt. Dadurch, dass das hBN nun nicht mehr in lockerer Pulverform vorliegt, sondern eine Vielzahl von Pulverteilchen mechanisch aneinander haften, d.h. Konglomerate bilden und diese Konglomerate mit der rauen Oberfläche vermutlich verzahnen, lässt sich das hBN nicht mehr einfach von der Oberfläche abreiben.

Vorzugsweise wurde der Festkörper mittels eines Sinterverfahrens gewonnen. Hierzu werden beispielsweise Pulvermassen von hBN so gewählt und vorgepresst, dass ein Zusammenhalt der Pulverartikel besteht. Anschliessend wird der so entstehende sogenannte vorgepresste Grünling unterhalb der Schmelztemperatur ausgehärtet und -verdichtet.

Vorzugsweise wird dem hBN Festkörper die Form eines Stiftes und oder einer Mine eines Stiftes gegeben. Als Stift ist im Rahmen dieser Beschreibung ein Körper zu verstehen, dessen Länge die Breite um mindestens eine Grössenordung überragt und dessen Höhe in derselben Grössenordnung liegt wie die Breite, wobei die Breite nicht grösser als 8mm ist. Gut bewährt haben sich Stifte in Zylinderform, dessen Minendurchmesser von 1 mm bis 5mm. Bevorzugt werden Durchmesser von 2-4mm verwendet. Eine solche Mine lässt sich besonders gut durch einen Minenschreiber handhaben, die derjenigen eines sogenannten Druckbleistifts entspricht. Dabei sind Fallminenstifte den Feinminenstiften vorzuziehen, da mit den standardmässigen Fallminenstiften grössere Minendurchmesser gehandhabt werden können.

Die Erfindung wird nun anhand eines Beispiels und mit Hilfe von Bildern im Detail dargestellt.

Das Beispiel bezieht sich auf eine Funkenverdampfungsquelle (ARC-Quellen), welche zur Beschichtung von Werkstücken unter Vakuum eingesetzt werden kann. ARC-Quellen benötigen einen elektrisch isoliert aufgehängten Confinementring, der dafür sorgt dass der Funken im Betrieb auf der Targetoberfläche verbleibt. Im Betrieb wird dieser Ring beschichtet und bis zu 700°C heiss. Im Beispiel wird der Ring aus rostfreiem Stahl hergestellt.

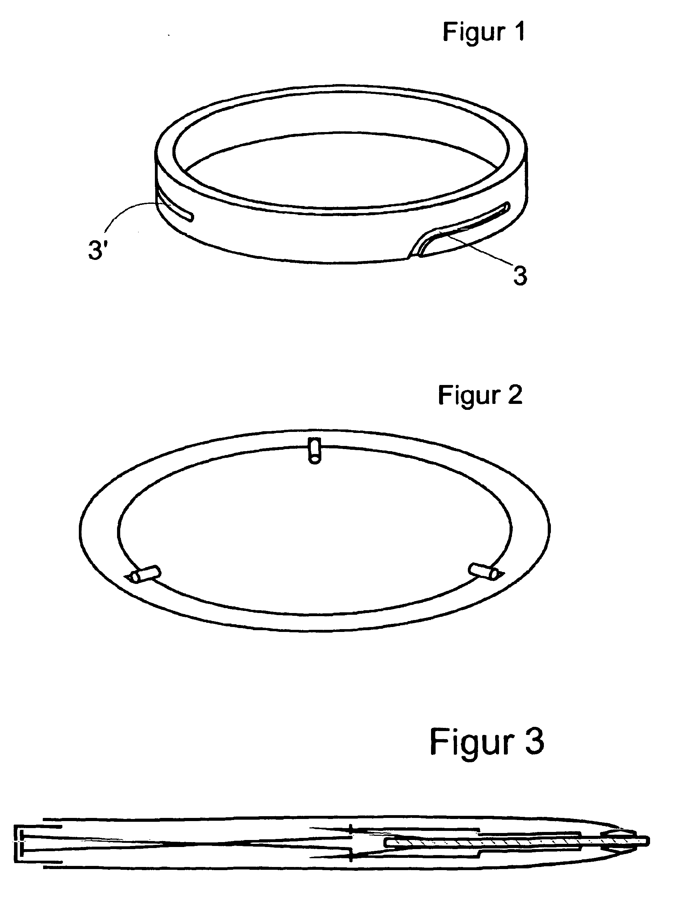

Für einen zuverlässigen Betrieb der ARC-Quelle muss die Beschichtung regelmässig vom Confinementring entfernt werden. Dies geschieht in der Regel durch Sandstrahlen des Confinementringes. Hierzu muss der Ring regelmässig ausgebaut werden. Es wird also eine elektrisch isolierende vakuumtaugliche Halterung des Confinementringes benötigt, die Temperaturen bis zu 700°C standhält und die es erlaubt, den Ring einfach auszubauen. Dies wird mit hier 3 seitlich am Confinementring eingefrässt Bajonettschlitzen 3, 3' (in der Figur 1 lediglich 2 sichtbar) erzielt, in welche elektrisch isolierende oder isoliert aufgehängte Pins der Ringhalterung eingreifen. Die Ringhalterung und die Pins sind in Figur 2 schematisch dargestellt.

Als Pinmaterial muss ein Material gewählt werden, welche sowohl mechanische Stabilität als auch die erforderliche Temperatursttabilität aufweisst und elektrisch isolierend ist. Hierfür kommt eine Keramik, wie zum Beispiel ZO₂, SiN oder Al₂O₃ in betracht, wobei Al₂O₃ am das kostengünstigste aber auch das brüchigste Material ist und SiN zwar am wenigsten brüchig, jedoch das teuerste Material ist. ZO₂ handelt es sich um einen guten Kompromiss aus Kosten und Stabilität.

Die Brüchigkeit spielt insofern eine Rolle, als durch die periodische Entnahme und den Einbau des Confinementringes regelmässig starke mechanische Beanspruchungen auf den Stiften lasten. Es kommt hinzu, dass durch das Sandstrahlen die Oberfläche des Confinementringes und insbesondere die Oberfläche der seitlichen Bajonettschlitze stark aufgeraut ist. Beim Aufdrehen oder Zudrehen des Bajonettverschlusses treten somit erhebliche Reibungskräfte auf, die leicht zu einem Abrechen der Pins führen können, wenn kein Schmiermittel vorhanden ist.

Erfindungsgemäss werden nun die Bajonettschlitze mit hBN "bemalt" indem mit einem zylindrischen Stift aus gesintertem hBN unter Aufwendung von Druck über die Oberfläche der Bajonetschlitze gerieben wird. Der zylindrische Stift hat einen Durchmesser, welcher kleiner ist als die Breite des Bajonettschlitzes, so dass er in den Schlitz eingeführt werden kann. Im Beispiel haben die Bajonettschlitze eine Breite von 5mm und der zylindrische hBN-Stift einen Durchmesser von 4mm. Der Druck, mit dem über die Oberfläche gerieben wird, sollte gross genug sein, um einen groben Abrieb des hBN-Materials sicherzustellen. Er sollte aber nicht so gross sein dass der hBN-Stift bricht. In der Praxis hat sich ein Druck zwischen 5bar und 50bar bewährt. Vorzugsweise wird ein Druck zwischen 10bar und 40bar angewendet. Besonders bevorzugt sind 30bar. Im Beispiel wurde bei einem Stiftdurchmesser von 4mm eine Kraft von ca. 30N aufgewendet. Für den Abrieb und die Haftung des hBN an der Oberfläche ist in diesem Zusammenhang von Vorteil dass die Oberfläche durch vorgängiges Sandstrahlen aufgeraut ist.

Wie bereits erwähnt kann der hBN-Stift direkt gehalten werden oder er kann in einer Minenhafterung, vorzugsweise in einer Fallminenhalterung gehaltert werden. Eine solche Fallminenhalterung ist schematisch in Figur 3 gezeigt. Durch die Halterung kann eine einfachere Handhabung erzielt werden. Standardmässig sind heute solche Halterungen für Bleistiftminen von bis zu 3.8mm Durchmesser erhältlich.

## Patentansprüche

1. Verfahren zum Aufbringen von hexagonalem Bornitrid als Schmiermittel auf eine Oberfläche, **dadurch gekennzeichnet dass** hexagonale Bohrnitrid in Form eines Festkörpers bereit gestellt wird und dieser Festkörper über die zu schmierende Oberfläche gerieben wird dergestalt, dass sich Bornitrid-Bestandteile vom Festkörper lösen und an der Oberfläche als Abrieb haften bleiben.

2. Verfahren nach Anspruch 1, **dadurch gekennzeichnet dass** der Festkörper im Wesentlichen durch Sinterung von hexagonalem Bornitrid gewonnen wird.

3. Verfahren nach einem der Ansprüche 1 und 2, **dadurch gekennzeichnet, dass** der Abrieb durch reiben mit einem Druck von mindestens 5bar, vorzugsweise zwischen 10bar und 40bar und besonders bevorzugt mit einem Druck von 30bar erzielt wird.

4. Anwendung des Verfahrens nach einem der vorangehenden Ansprüche auf Bajonettschlitze eines Confinementringes einer ARC-Quelle.

## Claims

1. Method for applying hexagonal boron nitride as lubricant onto a surface, **characterized in that** hexagonal boron nitride is prepared in the form of a solid piece and this solid piece is rubbed over the surface to be lubricated in such a manner that boron nitride components are abraded from the solid piece and adhere to the surface as abrasion.

2. Method according to claim 1, **characterized in that** the solid piece is obtained essentially through sintering of hexagonal boron nitride.

3. Method according to claim 1 or 2, **characterized in that** the abrasion is achieved through rubbing with a pressure of at least 5bar, preferably between 10bar and 40bar and particularly preferred with a pressure of 30bar.

4. Application of the method according to one of the preceding claims on bayonet slits of a confinement ring of an ARC source.

## Revendications

1. Procédé d'application de nitrure de bore hexagonal comme lubrifiant sur une surface, **caractérisé par le fait que** le nitrure de bore hexagonal est préparé sous forme d'un corps solide et que ce corps solide est frotté sur la surface à lubrifier de manière que des composants de nitrure de bore se détachent du corps solide et adhèrent à la surface comme abrasion.

2. Procédé selon la revendication 1, **caractérisé par le fait que** le corps solide est obtenu essentiellement grâce au frittage de nitrure de bore hexagonal.

3. Procédé selon la revendication 1 ou 2, **caractérisé par le fait que** l'abrasion est atteinte en frottant à une pression d'au moins 5bar, préférablement entre 10bar et 40bar et particulièrement preferablement à une pression de 30bar.

4. Application du procédé selon une des revendications précédentes aux fentes à baionette d'un anneau de confinement d'une source ARC.
